(19) **Europäisches Patentamt European Patent Office Office européen des brevets**

(11) **EP 3 252 508 B1**

(12) **FASCICULE DE BREVET EUROPEEN**

(45) Date de publication et mention de la délivrance du brevet:
**15.06.2022 Bulletin 2022/24**

(21) Numéro de dépôt: **17305427.1**

(22) Date de dépôt: **10.04.2017**

(51) Classification Internationale des Brevets (IPC):
***G01V 99/00*** *(2009.01)*

(52) Classification Coopérative des Brevets (CPC):
**G01V 99/005**

(54) **PROCÉDÉ D'EXPLOITATION DES HYDROCARBURES D'UNE FORMATION SOUTERRAINE, AU MOYEN D'UNE MISE À L'ÉCHELLE OPTIMISÉE**

VERFAHREN ZUR KOHLENWASSERSTOFFGEWINNUNG AUS EINER UNTERIRDISCHEN FORMATION MITHILFE EINER OPTIMIERTEN SKALIERUNG

METHOD FOR EXPLOITING HYDROCARBONS FROM AN UNDERGROUND FORMATION, BY MEANS OF OPTIMAL SCALING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.05.2016 FR 1654906**

(43) Date de publication de la demande:
**06.12.2017 Bulletin 2017/49**

(73) Titulaires:
• **IFP Energies nouvelles**
  **92500 Rueil-Malmaison (FR)**
• **Centre National de la Recherche Scientifique**
  **75794 Paris Cedex 16 (FR)**
• **Université de Nice**
  **06103 Nice Cedex 2 (FR)**

(72) Inventeurs:
• **ANTONINI, Marc**
  **06200 Nice (FR)**
• **PAYAN, Frederic**
  **06600 Antibes (FR)**
• **SCHNEIDER, Sébastien**
  **69560 Ste Colombe (FR)**
• **DUVAL, Laurent**
  **92000 Nanterre (FR)**
• **PEYROT, Jean-Luc**
  **69009 Lyon (FR)**

(74) Mandataire: **IFP Energies nouvelles**
  **Département Propriété Industrielle**
  **Rond Point de l'échangeur de Solaize**
  **BP3**
  **69360 Solaize (FR)**

(56) Documents cités:
WO-A1-2015/157186     US-A1- 2010 225 647
US-A1- 2013 346 049     US-A1- 2016 139 299

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention concerne le domaine de l'exploration et de l'exploitation des gisements pétroliers ou de sites de stockage géologique de gaz.

Plus particulièrement, la présente invention concerne la détermination d'une représentation maillée de propriétés pétrophysiques catégorielles d'une formation souterraine comportant des hydrocarbures, et ce en vue de la définition de schémas d'exploitation optimaux des hydrocarbures contenus dans la formation considérée.

L'exploration et l'exploitation d'un gisement, notamment pétrolier, nécessitent d'acquérir une connaissance aussi précise que possible de la géologie souterraine, et ce, afin de permettre une estimation des réserves, une estimation de la production, ou encore la définition de la gestion de l'exploitation du gisement dans le temps. En effet, la détermination de l'emplacement d'un puits de production ou d'un puits d'injection au sein d'un gisement d'hydrocarbures, la constitution de la boue de forage, les caractéristiques de complétion, le choix d'un procédé de récupération des hydrocarbures (tel que l'injection d'eau par exemple) et des paramètres nécessaires à la mise en œuvre de ce procédé (tels que la pression d'injection, le débit de production, etc.) nécessitent de bien connaître le gisement.

Pour acquérir cette connaissance, l'industrie pétrolière allie les mesures sur champ (réalisées in situ, lors de campagnes sismiques, de mesures dans des puits, de carottages etc.) aux modélisations expérimentales (réalisées au laboratoire) ainsi qu'aux simulations numériques (réalisées au moyen de logiciels, tels qu'un simulateur d'écoulement).

La formalisation de cette connaissance passe ensuite par l'établissement d'une maquette, aussi appelée modèle géologique, visant à rendre compte, de façon approchée, à la fois de la structure et du comportement d'un gisement. Ce type de maquette est généralement représentée sur un ordinateur, sous la forme d'une représentation maillée (qui peut être une grille régulière, ou bien un maillage structuré ou non structuré de façon plus générale), chacune des mailles de la représentation maillée comportant au moins une valeur d'une des propriétés précédemment évoquées.

Afin de représenter la grande variabilité du sous-sol, le modèle géologique est généralement constitué de mailles fines, c'est-à-dire de mailles dont les dimensions sont de l'ordre du pas de mesure (qui est généralement le pas des mesures sismiques). Bien que les capacités des ordinateurs s'améliorent avec le temps, aussi bien en termes de capacité de stockage que de capacité de calcul, les dimensions des zones d'intérêts des gisements étudiés s'accroissant et les pas de mesure diminuant, les modèles géologiques sont aujourd'hui constitués d'un très grand nombre de mailles (de l'ordre de la centaine de millions).

Or lorsqu'une représentation maillée respectant l'ensemble des données mesurées sur le terrain est finalement obtenue, cette représentation est utilisée pour prédire les déplacements de fluide dans la formation étudiée et planifier son développement futur, via la détermination de schémas d'exploitation optimaux. Pour ce faire, le spécialiste est amené à sélectionner les zones d'intérêt (présentant les niveaux d'hydrocarbures les plus élevés par exemple) dans lesquelles forer de nouveaux puits, à placer ces puits précisément dans les trois dimensions de l'espace, et à vérifier, par exemple via une simulation d'écoulement, si la production d'hydrocarbures avec cette implantation des puits est optimale.

Pour ce faire, et en particulier pour sélectionner les zones d'intérêts et placer les puits dans les trois dimensions de l'espace, le spécialiste a recours à une visualisation des informations disponibles, contenues notamment dans la représentation maillée de la formation étudiée. Cette visualisation se passe généralement sur écran d'ordinateur, à l'aide de logiciels permettant par exemple de visualiser des sections dans les différentes directions de l'espace, d'effectuer des rotations des volumes etc. La représentation maillée d'une formation souterraine étant constituée d'un très grand nombre de mailles, sa visualisation est bien souvent impossible à réaliser, ou lorsqu'elle est possible, l'interactivité est inopérante.

Par ailleurs, les moyens informatiques actuels ne permettent pas d'exécuter dans un temps raisonnable un simulateur d'écoulement, tel que le logiciel PumaFlow (IFP Energies nouvelles, France), sur des modèles géologiques fins et détaillés. En effet, à ce jour, le nombre de mailles que l'on utilise généralement pour simuler numériquement des écoulements est de l'ordre de la centaine de milliers.

Ainsi, les modèles géologiques fins sont, toujours à ce jour, difficilement exploitables, informatiquement notamment, en vue de la définition de schémas d'exploitation d'une formation souterraine optimaux.

## Etat de la technique

Les documents suivants seront cités au cours de la description :

[1] Christie, M.A., and Blunt, M.J., "Tenth SPE Comparative Solution Project: A Comparison of Upscaling Techniques", SPE Reservoir Engineering and Evaluation, 4, 308-317, (2001)

[2] P. Cignoni, C. Montani, and R. Scopigno. A comparison of mesh simplification algorithms. Computers & Graphics, 22:37-54, 1997.

[3] Callahan Steven P., Comba Joao L.D., Shirley Peter, Silva Claudio T. : Interactive rendering of large unstructured grids using dynamic level-of-detail. Visualization, 2005. VIS 05. IEEE, 199 - 206,

Afin de pouvoir exploiter les informations récoltées sur une formation souterraine d'intérêt, il est classique de construire des représentations maillées approchant de façon plus grossière la réalité que le modèle géologique à mailles fines.

Dans le cas où l'application visée est la simulation d'écoulement, on connaît la technique dite d' « upscaling » (« mise à l'échelle » en français) qui permet de passer d'une représentation à mailles fines à une représentation à mailles grossières, aussi appelée modèle de réservoir. La technique d'upscaling est par exemple décrite dans le document [1]. De façon générale, cette technique consiste à calculer un modèle grossier qui soit équivalent au modèle fin du point de vue des propriétés dynamiques (c'est-à-dire des propriétés liées à l'écoulement des fluides, telles que la perméabilité). Le fondement de l'upscaling est donc l'homogénéisation des propriétés dynamiques de la formation. La plus simple des techniques d'homogénéisation consiste à effectuer, pour chacune des mailles de la représentation grossière, une moyenne des valeurs des propriétés dynamiques se trouvant dans le groupe de mailles du modèle géologique correspondant à ladite maille grossière. Dans le cas d'une propriété catégorielle telle que la lithologie, chaque valeur de la propriété définit une classe donnée (par exemple, on attribue la valeur 10 aux mailles de la représentation contenant du calcaire, la valeur 20 aux mailles contenant de l'argile, et la valeur 50 aux mailles contenant des sables). Effectuer une moyenne, ou plus généralement une homogénéisation, n'a de fait pas de sens dans le cas de propriétés catégorielles. Dans ce cas, il est classique d'attribuer à la maille grossière la valeur de la propriété prédominante dans le groupe de mailles correspondant, éventuellement pondérée par le volume de roche ou le volume poreux. L'étape d'upscaling peut être réalisée par exemple à l'aide du logiciel CobraFlow (IFP Energies nouvelles, France).

En matière de visualisation de représentations maillées, lorsqu'un modèle numérique atteint une taille et une précision qui ne permet plus à l'ensemble de l'information de pouvoir s'afficher sur un écran d'ordinateur, on fait couramment appel à des techniques dites de « niveau de détails » qui vont simplifier le modèle afin de pouvoir afficher une information que l'utilisateur pourra interpréter visuellement (voir notamment les documents [2] et [3]). Les techniques de niveau de détail passent par une simplification du modèle numérique qui introduit une perte de précision. En général une opération de décimation est appliquée sur le maillage afin de réduire le nombre d'éléments géométriques affichés à l'écran. Cette décimation va dépendre de l'angle de vue (angle sous lequel est visualisé le volume) et de la zone observée. Les opérateurs utilisés pour décimer (contraction d'arêtes, fusion de sommets, fusion de faces notamment), même lorsqu'ils s'appuient sur une métrique d'erreur minimisant les déformations, introduisent une perte de précision et éventuellement des artefacts dans les zones de discontinuité.

On connait en outre le document WO 2015/157186 A1 qui concerne un procédé amélioré pour modéliser des formations géologiques.

Dans tous les cas, que ce soit pour l'upscaling (en vue par exemple d'une simulation de réservoir) ou pour la visualisation (en vue de l'implantation de puits par exemple) d'une représentation maillée, les procédés pour passer d'une représentation à mailles fines à une représentation à mailles plus grossières ne sont pas prévus pour être réversibles, ce qui nécessite de conserver les représentations maillées déterminées à toutes les échelles. De plus, l'exploitation pétrolière d'une formation souterraine pouvant durer plusieurs dizaines d'années, on peut être amené à déterminer plusieurs représentations maillées d'une même formation, à différentes échelles, mais aussi à différents instants au cours de l'histoire de l'exploitation de la formation. Il est donc dans ce cas nécessaire de stocker de gros volumes d'informations pour l'exploitation d'une même formation souterraine au cours du temps.

La présente invention concerne un procédé pour passer d'une représentation à mailles fines à au moins une autre représentation à mailles plus grossières (on parlera de résolution inférieure dans la suite), dans le cas où la propriété étudiée est une propriété catégorielle, tout en conservant des paramètres de passage entre chaque résolution, ces paramètres permettant la reconstitution exacte de la représentation à mailles fines initiale. De plus, la conservation de ces paramètres de passage peut demander moins de ressources de mémoire que la conservation de la représentation maillée de résolution directement supérieure.

## Le procédé selon l'invention

Ainsi, la présente invention concerne un procédé d'exploitation d'une formation souterraine comportant des hydrocarbures, à partir de mesures d'au moins une propriété catégorielle relative à ladite formation, dans lequel on construit une première représentation maillée représentative de ladite formation, chaque maille de ladite première représentation comportant une valeur de ladite propriété catégorielle, et dans lequel, à partir de ladite première représentation maillée, on construit au moins une seconde représentation maillée de la dite formation, la résolution de ladite seconde représentation étant inférieure à la résolution de ladite première représentation, de sorte qu'une maille de ladite seconde représentation corresponde à un groupe de mailles de ladite première représentation. Le procédé selon l'invention est mis en œuvre, pour chacune desdites mailles de ladite seconde représentation et pour ladite propriété, selon au moins les étapes suivantes :

A. on détermine une valeur représentative des valeurs de ladite propriété dans lesdites mailles dudit groupe de mailles de ladite première représentation correspondant à ladite maille de ladite seconde représentation, et on assigne ladite valeur représentative à ladite maille de ladite seconde représentation ;

B. on détermine des paramètres de passage de ladite seconde représentation à ladite première représentation au moyen d'une combinaison linéaire appliquée entre la valeur assignée à ladite maille de ladite seconde représentation et les valeurs de ladite propriété dans les mailles du groupe de mailles de ladite première représentation correspondant à ladite maille de ladite seconde représentation, lesdits paramètres de passage permettant de reconstruire ladite première représentation à partir de ladite seconde représentation, ladite combinaison linéaire consistant en une soustraction;

Puis, au moyen d'au moins ladite seconde représentation, desdits paramètres de passage et de ladite combinaison linéaire, on détermine au moins un schéma d'exploitation optimal des hydrocarbures de ladite formation, et on exploite ladite formation en fonction dudit schéma d'exploitation.

Selon un mode de mise en œuvre de l'invention, ladite détermination dudit schéma d'exploitation peut comprendre la détermination itérative d'une série de N représentations maillées Rn de résolution inférieure à la résolution de ladite première représentation R1, avec n variant entre 3 à N, la détermination de la nième représentation Rn pouvant être réalisée selon au moins les étapes suivantes :

i on reconstitue ladite première représentation R1 au moyen de ladite représentation Rn-1, desdits paramètres de passage et de ladite combinaison linéaire déterminés à l'itération n-1 ;

ii on applique lesdites étapes A et B à partir de ladite première représentation reconstituée R1 et pour ladite nième représentation Rn.

Avantageusement, au moins une desdites représentations maillées de résolutions inférieures à la résolution de ladite première représentation peut être déterminée dans au moins une zone d'intérêt de ladite formation, telle qu'une zone le long d'un puits, une zone le long d'un horizon, une zone le long d'une faille.

Selon un mode de mise en œuvre de l'invention, ladite valeur représentative peut correspondre à la valeur de ladite propriété ayant la plus forte occurrence et/ou la plus grande longueur de corrélation dans ledit groupe de mailles de ladite première représentation.

Selon un mode de mise en œuvre de l'invention, lesdites étapes A et B peuvent être réitérées pour chacune des propriétés catégorielles relatives à ladite formation.

Selon un mode de mise en œuvre de l'invention, on peut déterminer un schéma d'exploitation optimal au moyen d'au moins une visualisation desdites représentations maillées de résolutions différentes et/ou au moyen de simulations d'écoulement réalisées sur des représentations maillées de résolutions différentes.

Selon un mode de mise en œuvre de l'invention, ladite propriété catégorielle peut correspondre à une lithologie, une perméabilité relative après classification, une pression fluide après classification, ou une saturation en huile après classification.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon la description ci-dessus, lorsque ledit programme est exécuté sur un ordinateur.

D'autres caractéristiques et avantages du procédé selon l'invention, apparaîtront à la lecture de la description ci-après d'exemples non limitatifs de réalisations, en se référant aux figures annexées et décrites ci-après.

**Présentation succincte des figures**

- Les Figures 1A et 1B illustrent schématiquement une variante de mise en œuvre du procédé selon l'invention pour une première représentation maillée comportant 6×4×4 mailles.

- La Figure 2A présente un exemple de modèle géologique pour l'application du procédé selon l'invention. Les Figures 2B, 2C et 2D présentent des représentations maillées de résolutions décroissantes obtenues par l'application du procédé selon l'invention.

**Description détaillée du procédé**

Les définitions suivantes sont utilisées au cours de la description de l'invention :

- propriété catégorielle : il s'agit d'un ensemble fini de valeurs symboliques, représentées par des catégories (par exemple les catégories C0, C1, C2, etc). Un exemple de propriété catégorielle est la lithologie, pour laquelle les différentes catégories correspondent aux différents types de roche (par exemple les 'grès', 'sable', 'calcaire', 'argile', etc.). On peut aussi obtenir une propriété catégorielle après l'application d'une classification à une propriété donnée, la classification étant une méthode bien connue des spécialistes consistant à regrouper des points par famille, les points d'une même famille présentant des caractéristiques communes. Une classification peut être appliquée à une propriété pétrophysique donnée de la formation étudiée, mais plus généralement à un attribut de la formation étudiée, un attribut résultant par exemple d'une combinaison linéaire appliquée à au moins une propriété pétrophysique. La classification peut, par exemple, être réalisée au moyen d'une méthode de classification, telle que la méthode du K-means, bien connue du spécialiste. Il est ainsi classique dans le domaine de l'exploitation d'une formation souterraine d'utiliser la classification pour déterminer les zones de la formation étudiée ayant des caractéristiques similaires (par exemple en termes de hauteur d'huile et/ou de gaz, de perméabilité relative à l'huile et/ou au gaz et/ou à l'eau, la perméabilité horizontale, la pression de fluide, la saturation en huile et/ou en gaz et/ou en eau). Lorsque des propriétés catégorielles doivent être exploitées sur ordinateur, par des logiciels de simulation numérique (par exemple une simulation d'écoulement) ou bien à des fins de visualisation, ces propriétés sont représentées par des entiers.

- résolution d'une représentation maillée : il s'agit d'une mesure de la finesse des détails d'une représentation maillée, directement liée aux dimensions physiques des mailles dans toutes les directions de l'espace. Ainsi une représentation maillée a une résolution inférieure à celle d'une autre représentation maillée lorsque au moins une des dimensions de ses mailles, dans au moins une des directions de l'espace, est plus grande. Dans le cas où le rapport entre les dimensions des représentations maillées de résolution différente est un entier, une maille de la représentation maillée de résolution inférieure correspond (c'est-à-dire regroupe ou contient) à un groupe de mailles de la représentation maillée de résolution supérieure (à l'exception éventuelle des effets de bord).

De façon générale, l'invention concerne un procédé d'exploitation d'une formation souterraine comportant des hydrocarbures, comprenant notamment la détermination d'au moins un schéma d'exploitation optimal des hydrocarbures de ladite formation.

Plus particulièrement, l'invention concerne, à partir d'une première représentation maillée d'une formation souterraine, chaque maille de la première représentation comportant une valeur d'au moins une propriété catégorielle, la construction d'au moins une seconde représentation maillée de la formation étudiée, caractérisée par des dimensions de mailles plus grande (dans au moins une direction de l'espace, et de préférence au moins dans les deux directions latérales de l'espace) que celles de la première représentation maillée, et comportant une valeur de la propriété catégorielle considérée. Selon l'invention, cette seconde représentation maillée, de résolution plus basse, est ensuite avantageusement utilisée en vue de la détermination d'un schéma d'exploitation optimal du fluide contenu dans la formation souterraine étudiée.

Pour la mise en œuvre du procédé selon l'invention, la propriété catégorielle considérée est représentée par des valeurs entières discrètes, de préférence par des valeurs entières consécutives.

La présente invention est déclinée ci-après, de façon non limitative, dans le cas de représentations maillées tridimensionnelles, mais le procédé selon l'invention est applicable à des représentations maillées de dimension quelconque.

La présente invention requiert de disposer au moins de :

- mesures d'au moins une propriété catégorielle relative à ladite formation : il s'agit de mesures réalisées in situ (par exemple par carottage, par des étude d' affleurements, via des diagraphies réalisées dans des puits, par des campagnes d'acquisition sismique etc), en différents points de la formation étudiée, mesures à partir desquelles on peut déterminer une valeur de la propriété catégorielle étudiée (c'est-à-dire, de façon plus générale, la catégorie ou la classe de la propriété considérée à laquelle cette mesure appartient) pour chacun des points de mesure considérés. Lorsque la propriété catégorielle étudiée est la lithologie, on peut par exemple exploiter de façon directe les carottes prélevées sur site afin d'en déduire la lithologie présente au point de prélèvement de la carotte, réaliser et interpréter des diagraphies de type gamma-ray couplées à des diagraphies de densité par exemple, afin d'en déduire la lithologie le long des puits dans lesquels les outils diagraphiques sont insérés, réaliser une campagne d'acquisition sismique et exploiter ces données, par exemple via une inversion stratigraphique afin d'extrapoler de manière physique les informations entre puits et de déterminer les limites des couches géologiques matérialisant les changements de lithologie. Ces mesures sont notamment utilisées pour construire une première représentation maillée (à mailles fines) de la formation étudiée. Avantageusement, on peut réaliser en outre des mesures permettant d'accéder à des informations sur les propriétés pétrophysiques non catégorielles de la formation étudiée (telles que la perméabilité, les saturations en fluide, etc), ou encore on peut exploiter des données de production (comme les débits d'huile, d'eau, les variations de pression etc) de manière à construire une représentation maillée qui pourra être utilisée à des fins de simulation d'écoulement ;

- une première représentation maillée représentative de la formation étudiée : il s'agit d'une première maquette de la formation souterraine étudiée, représentée généralement sur ordinateur sous la forme d'un maillage ou grille, chacune des mailles de cette grille comportant une ou plusieurs valeurs de propriétés relatives à la formation étudiée (dans le cas présent, au moins une propriété catégorielle telle que la lithologie). Le plus souvent dans la mise en œuvre de l'invention, cette première représentation maillée correspondra au modèle géologique, construit dans le but de décrire aussi précisément que possible la structure et les propriétés (dans le cas présent, au moins une propriété catégorielle telle que la lithologie) de la formation étudiée. Un modèle géologique se doit de vérifier autant que possible les propriétés relatives à la formation étudiée collectées sur le terrain : les données de diagraphie mesurées le long des puits, les mesures réalisées sur des échantillons de roche prélevés dans les puits, les données déduites de campagnes d'acquisition sismique, ou encore des données de production comme les débits d'huile, d'eau, les variations de pression etc. Le modèle géologique a généralement des mailles fines (en principe, les dimensions des mailles dépendent de la résolution des données sismiques, qui aujourd'hui peut être de l'ordre de 5m latéralement et verticalement), et par voie de conséquence un nombre de mailles important. Le spécialiste en exploration et exploitation pétrolière a pleine connaissance de techniques pour construire une telle représentation maillée d'une formation.

La présente invention comporte au moins les étapes suivantes :

1. Construction d'une seconde représentation maillée

    1.1. Détermination d'une valeur de propriété catégorielle représentative

    1.2. Détermination de paramètres de passage

2. Détermination d'un schéma d'exploitation optimal

3. Exploitation de la formation

Les principales étapes de la présente invention sont détaillées ci-après.

1. Construction d'une seconde représentation maillée

Il s'agit au cours de cette étape, à partir de la première représentation maillée représentative de la formation étudiée, de construire une seconde représentation maillée représentative de la formation, chaque maille de la seconde représentation correspondant à un groupe de mailles de la première représentation. Autrement dit, on construit, à partir d'une première représentation maillée (qui peut correspondre au modèle géologique à mailles fines comme à toute représentation maillée de résolution quelconque) une seconde représentation de la formation étudiée caractérisée par des mailles de dimensions supérieures, une maille de la seconde représentation contenant alors un groupe de mailles (c'est-à-dire au moins deux mailles, à l'exception éventuellement des bords lorsque l'une des dimensions des mailles de la deuxième représentation ne correspond pas à un multiple de la dimension équivalente des mailles de la première représentation) de la première représentation. L'objectif de cette étape est donc de construire une (seconde) représentation maillée de plus basse résolution que la (première) représentation maillée en entrée de l'étape.

Selon une mise en œuvre, chaque maille de la seconde représentation maillée (sauf pour les mailles de bordure) comporte un nombre de mailles identiques dans toutes les dimensions considérés. Par exemple, une maille de la seconde représentation peut comprendre 8, 27, 64, 125... mailles de la première représentation.

Par la suite et à des fins de simplification de l'exposé de l'invention, on appellera « grille grossière » la seconde représentation maillée, et « grille fine » la première représentation maillée. On notera également (DFi, DFj, DFk) les dimensions dans les trois directions de l'espace (i,j,k) des mailles de la grille fine, et (DGi, DGj, DGk) les dimensions dans les trois directions de l'espace (i,j,k) des mailles de la grille grossière, avec au moins un des rapports $\frac{DGi}{DFi}$, $\frac{DGj}{DFj}$

$\dfrac{DGk}{DFk}$ supérieur ou égal a 2. Les dimensions peuvent être exprimées en nombre de mailles par rapport à une référence ou bien en dimensions physiques. Les dimensions des mailles de la grille grossière sont déterminées par le spécialiste, par exemple par le spécialiste en simulation d'écoulement qui peut déterminer ces dimensions en fonction des capacités de calcul de l'ordinateur sur lequel est exécutée la simulation d'écoulement. Le spécialiste peut par exemple choisir une dimension de mailles de la grille grossière dans une direction de l'espace donnée comme étant égale à un multiple de la dimension dans cette même direction des mailles de la grille fine.

Le procédé selon l'invention comporte deux sous-étapes qui sont à appliquer pour chaque propriété catégorielle considérée, et pour chacune des mailles de la grille grossière. Ces sous-étapes sont détaillées ci-après.

## 1.1 Détermination d'une valeur de propriété catégorielle représentative

Au cours de cette sous-étape, il s'agit d'attribuer une valeur de propriété catégorielle représentative à la maille de la grille grossière considérée. Selon l'invention, cette valeur correspond à une valeur représentative de l'ensemble des valeurs de propriété catégorielle contenues dans les mailles du groupe de mailles de la grille fine correspondant à la maille de la grille grossière considéré.

Selon un mode de mise en œuvre de l'invention, la valeur représentative à attribuer à la maille de la grille grossière correspond à la valeur de la propriété catégorielle considérée dont l'occurrence est la plus forte dans le groupe de mailles de la grille fine correspondant. Selon un autre mode de mise en œuvre de l'invention, on peut déterminer la valeur représentative à attribuer à la maille de la grille grossière comme étant la valeur de la propriété catégorielle ayant la plus grande longueur de corrélation dans le groupe de mailles de la grille fine correspondant (ce qui signifie que l'on privilégie la répétition d'une valeur de propriété catégorielle donnée d'une maille à une maille directement voisine dans un groupe de mailles de la grille fine).

Selon une variante de réalisation du procédé selon l'invention, on détermine la valeur représentative comme étant la valeur de la propriété catégorielle considérée ayant à la fois l'occurrence et la longueur de corrélation les plus fortes dans le groupe de mailles de la grille fine correspondant. Selon une autre variante de réalisation du procédé selon l'invention, et par exemple lorsque la propriété catégorielle étudiée est la lithologie, on peut en outre prendre en compte le rapport entre le volume de roche et le volume poreux. Ces variantes permettent de faire un choix non arbitraire dans les cas où plusieurs valeurs de propriété catégorielle auraient la même occurrence et/ou la même longueur de corrélation.

Par la suite, on appellera « mode » la valeur de propriété catégorielle représentative d'un groupe de mailles de la grille fines considéré. Selon l'invention, ce mode est assigné dans la maille de la grille grossière correspondant au groupe de mailles de la grille fine considéré.

Selon un mode de mise en œuvre de l'invention, on conserve, en plus de la valeur représentative d'un groupe de mailles de la grille fine considéré, la position de ce mode dans le groupe de mailles considéré. Cette conservation peut se faire dans un tableau, comme par exemple un tableau informatique. Avantageusement, si on note $(i,j,k)$ la position de la maille de la grille fine ainsi identifiée, on peut conserver la position du mode sous forme linéaire, par exemple selon une formule du type : $DG'i * DG'j * k + DG'i * j + i$, où $DG'i, DG'j$ sont les dimensions de la grille grossière dans les directions de l'espace $(i,j)$ exprimées en nombre de mailles par rapport à la grille fine. Cette représentation de la position permet la conservation de l'information dans un tableau à une seule dimension contenant un seul entier, ce qui avantageux en termes de taille mémoire, notamment informatique.

## 1.2 Détermination de paramètres de passage

Au cours de cette sous-étape, il s'agit de déterminer des paramètres de passage de la grille grossière à la grille fine, c'est-à-dire des paramètres permettant de reconstruire la grille fine à partir de la grille grossière. Selon l'invention, la détermination de ces paramètres de passage est basée sur l'application d'une combinaison linéaire fonction de la valeur assignée à la maille de la grille grossière (c'est-à-dire la valeur représentative déterminée à la sous-étape précédente ou mode) et des valeurs dans les mailles du groupe de mailles de la grille fine correspondant à la maille de la grille grossière considérée. Selon l'invention, la combinaison linéaire est une soustraction appliquée entre la valeur assignée à la maille de la grille grossière et les valeurs dans les mailles du groupe de mailles de la grille fine correspondant, pondérée par toute constante, ainsi que l'ajout de toute constante au résultat de cette opération arithmétique. Par exemple, si on note XG la valeur assignée à la maille de la grille grossière et XF la valeur dans une des mailles du groupe de mailles de la grille fine correspondant à la maille grossière considérée, les paramètres de passage P peuvent être évalués selon une formule du type : $P = aXF.OA.XG + b$, où OA est une opération arithmétique appliquée entre XG et XF, et a et b sont des constantes. Selon l'invention, le résultat de cette combinaison linéaire est conservé, par exemple dans un tableau informatique. A partir du résultat de cette combinaison linéaire pour chacune des mailles de la grille fine correspondant à la maille de la grille grossière considérée, on peut retrouver, en appliquant l'« inverse » de la combinaison linéaire (en inversant les opérations arithmétiques de la combinaison linéaire notamment), chacune des valeurs de la grille fine telle qu'initialement remplie. Par exemple, à partir des paramètres de passage P et des valeurs de la grille grossière XG tels que définis précédemment, on peut retrouver les valeurs de la grille fine par application de l'opération arithmétique inverse OA$^{-1}$' selon une formule du type : $XF = \frac{(P-b)}{a}.OA^{-1}.XG$. De cette manière, la détermination d'une représentation maillée de résolution plus basse pouvant être réversible, il n'est pas nécessaire de conserver la représentation maillée initiale, ce qui est très avantageux en termes d'espace mémoire de stockage.

Selon l'invention, la combinaison linéaire en question consiste en une soustraction (et son inverse est alors une addition), appliquée entre la valeur assignée à la maille de la grille grossière et les valeurs dans les mailles du groupe de mailles de la grille fine correspondant. Plus précisément, il s'agit de réaliser, pour chaque groupe de mailles, la différence entre la valeur de la propriété catégorielle dans chacune des mailles du groupe de mailles considéré et la valeur représentative assignée à la maille de la grille grossière correspondant au groupe de mailles considéré. Selon l'invention, le résultat de ces différences est conservé, par exemple dans un tableau informatique. Quelle que soit la maille du groupe de mailles considéré, la valeur de la différence est nécessairement inférieure à la valeur de la propriété catégorielle initiale, voire nulle dans le cas où la valeur dans la maille du groupe de mailles considéré était égale à la valeur représentative (ou mode) déterminée au cours de la sous-étape précédente. Lorsque les différences sont stockées informatiquement, il s'ensuit que le nombre d'octets (regroupement de 8 bits codant une information) pour les stocker est inférieure au nombre d'octets nécessaires pour stocker les valeurs initiales, avant différence. Par conséquent, le tableau informatique dans lequel sont stockées les différences est, en taille mémoire, moins volumineux que celui conservant les valeurs initiales. Etant donné le nombre de mailles qui peut être de l'ordre de plusieurs dizaines de millions dans le maillage fin, cela peut représenter des dizaines de Giga-octets de mémoire libérée. De plus, le fichier informatique résultant étant plus petit, cela permet un temps de transfert de ce fichier beaucoup moins long, ce qui est particulièrement avantageux et recherché lors des multiples accès aux fichiers informatiques requis lors de simulations numériques réalisées par exemple sur supercalculateur.

Selon un mode de mise en œuvre de l'invention dans lequel on a déterminé, lors de la sous-étape 1.1, un mode pour le groupe de mailles considéré et en outre la position de ce mode, on peut réaliser la combinaison linéaire décrite ci-dessus et conserver le résultat uniquement pour les mailles du groupe de mailles considéré à l'exclusion de celle correspondant audit mode, et ce pour chaque mode. En effet, la valeur du mode et sa position étant conservée, le spécialiste sait le replacer dans la représentation maillée initiale.

Selon un autre mode de mise en œuvre de l'invention, on réitère l'étape 1 pour les différentes propriétés catégorielles disponibles concernant la formation étudiée, comme par exemple des propriétés catégorielles portant sur la quantité d'hydrocarbures, sur la nature de ces hydrocarbures, sur la pression dans la maille étudiée, etc. Selon un mode de mise en œuvre de l'invention, cette réitération peut se faire à différents instants dans l'histoire de l'exploitation d'une formation souterraine, des informations sur une propriété catégorielle donnée, ou bien des informations sur une nouvelle propriété catégorielle, non encore prise en compte dans le procédé selon l'invention, pouvant être accessible à tout moment au cours de l'exploitation de la formation souterraine étudiée.

## 2- Détermination d'un schéma d'exploitation optimal de la formation

Au cours de cette étape, il s'agit de définir, à partir d'au moins la seconde représentation maillée, des paramètres de passage associés et de la combinaison linéaire déterminés à l'étape précédente, au moins un schéma d'exploitation optimal du fluide contenu dans la formation, c'est-à-dire un schéma d'exploitation permettant une exploitation optimale d'un fluide considéré suivant des critères technico-économiques prédéfinis par le spécialiste.

La définition d'un schéma d'exploitation du fluide de la formation étudiée peut consister à choisir un type de procédé de récupération (par exemple un procédé de récupération par injection d'eau), puis à déterminer, pour ce type de procédé, le nombre, la géométrie et l'implantation (position et espacement) des puits injecteurs et producteurs favorisant la progression des fluides au sein du réservoir. Le spécialiste élabore généralement différents scénarii de production (nombre, implantation et géométrie des puits injecteurs et/ou producteurs) et estime le taux de récupération de chacun de ces scénarii, par exemple à l'aide d'un simulateur d'écoulement, tel que le logiciel PumaFlow (IFP Energies nouvelles, France). Le schéma d'exploitation offrant le meilleur taux de récupération de fluide pour un coût le plus faible sera par exemple préféré.

La détermination d'un schéma d'exploitation optimal comprend le plus souvent une étape de visualisation, par exemple sur un écran d'ordinateur, des informations disponibles sur la formation étudiée, ce qui inclut la visualisation des informations catégorielles. Par exemple, à partir d'une visualisation des zones comportant le plus grand taux d'hydrocarbures ou encore des zones de surpression, le spécialiste peut déterminer la ou les zones de la formation étudiée dans laquelle l'implantation d'un puits est la plus opportune, ainsi que la géométrie dans l'espace de ce puits. Dans la pratique, la visualisation de cette information est le plus souvent multi-résolution, c'est-à-dire qu'elle s'effectue à des niveaux de résolutions différents, de manière notamment à préciser graduellement les zones d'intérêt et/ou le positionnement des puits à implanter.

Par ailleurs, la détermination d'un schéma d'exploitation optimal passe généralement par des simulations d'écoulement répétées, notamment pour tester différents scenarii de positionnement de puits, de procédé de récupération etc. Selon un mode de mise en œuvre de l'invention, le spécialiste peut réaliser des essais de simulation d'écoulement sur une série de grilles dégradées de la grille fine initiale, c'est-à-dire une série de grilles de résolutions différentes entre elles et toutes inférieures à celle la grille fine initiale. Ainsi par exemple, le spécialiste peut décider de réaliser dans un premier temps des essais sur une grille dont les dimensions des mailles sont égales à dix fois celles de la grille fine, puis en fonction de la cohérence des résultats obtenus avec les données de production réelles, faire un nouvel essai avec des dimensions de mailles égales à cinq fois celles de la grille fine, etc.

Ainsi, selon un mode de mise en œuvre de l'invention pouvant servir notamment aux fins de la visualisation multi-résolution et/ou des essais d'écoulement multi-résolution, on détermine une série de N représentations maillées $R_n$ représentatives de ladite formation, chaque représentation ayant une résolution inférieure à la résolution de la représentation fine initiale $R_1$ (préférentiellement chaque représentation a une résolution propre, c'est-à-dire que les résolutions des $R_n$ représentations sont différentes les unes des autres ; par exemple au moins une des dimensions des mailles est différente d'une représentation à une autre), avec n variant entre 1 à N, les représentations $R_1$ et $R_2$ de cette série correspondant respectivement aux première et seconde représentations préalablement déterminées à l'étape 1 telle que décrite précédemment. La détermination de la $n^{ième}$ représentation $R_n$, avec n variant entre 3 et N, est réalisée selon au moins les étapes suivantes :

i on reconstitue la première représentation $R_1$ au moyen de la représentation $R_{n-1}$, des paramètres de passage et de la combinaison linéaire déterminés à l'itération n-1 ;

ii on applique les étapes A et B à partir de la première représentation $R_1$ ainsi reconstituée, et de façon à déterminer ladite $n^{ième}$ représentation maillée $R_n$.

Ainsi, grâce au procédé selon l'invention, il n'est pas nécessaire de conserver les représentations maillées pour chacune des résolutions puisqu'il est suffisant de conserver une seule représentation maillée, à une résolution donnée, et ses paramètres de passage associés, de manière à reconstituer la représentation maillée initiale puis à déterminer des représentations maillées de résolution inférieure. Préférentiellement et afin de réduire le stockage en mémoire, à l'issue d'une itération n donnée, on efface informatiquement les paramètres de passage et la représentation maillée déterminés à l'itération n-1, ainsi que la représentation maillée initiale reconstituée.

Selon un mode de mise en œuvre de l'invention impliquant au moins une visualisation multi-résolution de représentations maillées, la détermination de la série de N représentations maillées peut se faire « à la volée », c'est-à-dire au fur et à mesure de la visualisation, sur un écran d'ordinateur par exemple.

Selon un mode de mise en œuvre de l'invention impliquant au moins une visualisation multi-résolution de représentations maillées, on peut ne mettre en œuvre le procédé selon l'invention que pour (au moins) une portion d'une représentation maillée d'une formation souterraine, comme par exemple dans une zone d'intérêt de la formation étudiée, telle que le long d'un puits, d'un horizon, d'une faille. Ainsi, on peut ne calculer que des portions d'une (ou de plusieurs) représentation(s) maillée(s) de résolution(s) inférieure(s), dans des zones d'intérêt. Ce mode de mise en œuvre peut être particulièrement avantageux par exemple dans la phase de positionnement d'un puits (qui se doit d'être extrêmement précise), car il permet de réduire les temps de calcul et donc améliore l'interactivité de la visualisation. Avantageusement, on conserve la première représentation maillée détaillée pour l'ensemble de la formation et on applique le procédé selon l'invention à une portion de la représentation maillée initiale.

Selon un mode de mise en œuvre de l'invention, les dimensions des mailles de la représentation maillée à une itération n (avec n variant entre 3 et N) sont doublées par rapport aux dimensions des mailles de la représentation maillée déterminée à l'itération précédente n-1.

Selon un mode de mise en œuvre de l'invention impliquant au moins une visualisation multi-résolution de représentations maillées, afin de satisfaire à des exigences d'interactivité de la visualisation, des représentations maillées intermédiaires (par exemple toutes les 3 itérations) ainsi que leurs paramètres de passage associés sont avantageusement conservés.

Ainsi, en ne nécessitant de ne garder qu'une seule grille de résolution quelconque et ses paramètres de passage associés, la présente invention permet un gain en place mémoire très important, ce qui est très avantageux tout au long de l'histoire de l'exploitation d'une formation souterraine.

3- Exploitation de la formation

Puis, selon l'invention, on exploite le fluide (les hydrocarbures) de la formation étudiée en fonction d'au moins un des schémas d'exploitation optimaux déterminés à l'étape précédente. Ainsi, les spécialistes exploitent le fluide de la formation considérée selon le scénario permettant d'optimiser la production de ce fluide défini à l'étape précédente, notamment, en forant au moins un des puits producteurs, dont le nombre et/ou l'implantation ont été déterminés à l'étape précédente, de façon à extraire les hydrocarbures de la formation étudiée.

**Produit programme d'ordinateur**

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, lorsque ledit programme est exécuté sur un ordinateur.

**Exemples d'application**

Les caractéristiques et avantages du procédé selon l'invention apparaîtront plus clairement à la lecture des exemples d'application ci-après.

**Exemple 1**

Le premier exemple présenté ci-après est un exemple purement illustratif des différentes étapes du procédé selon l'invention et de ces variantes.

Pour cet exemple, la première représentation maillée ou grille fine est constituée de 6x4x4 mailles, chaque maille contenant une valeur catégorielle. Le procédé selon l'invention est appliqué de sorte à déterminer une grille grossière de taille 3x2x2 mailles. Autrement dit, chaque maille de la grille grossière correspond à un groupe de 2x2x2 mailles de la grille fine.

Cet exemple de réalisation de l'invention est mis en œuvre de la façon suivante :

- afin de déterminer la valeur représentative, ou mode, de chaque groupe de mailles de la grille fine correspondant à une maille de la grille grossière, on utilise le critère défini à la sous-étape 1.1, basé sur la valeur de propriété catégorielle ayant l'occurrence la plus forte combinée à la longueur de corrélation la plus forte ;

- la combinaison linéaire considérée pour l'application de la sous-étape 1.2 est une soustraction ;

- on conserve dans un tableau T1 la position du mode déterminé pour chaque groupe de mailles, sous forme de position linéaire telle que définie à la sous-étape 1.2 ;

- on conserve dans un seul et même tableau T2 à la fois les valeurs représentatives ou modes (cf sous-étape 1.1), ainsi que les paramètres de passage (cf sous-étape 1.2), ces paramètres de passage n'étant pas évalués pour les mailles de la grille fine correspondant aux positions des modes (cf sous-étape 1.2).

Plus précisément, le procédé selon l'invention est mis en œuvre de la façon suivante pour cet exemple :

- on parcourt chaque groupe de mailles de la grille fine, chaque groupe contenant 8 valeurs entières dans un intervalle que l'on note [Vmin, Vmax], et on détermine un mode pour chaque groupe ainsi que sa position (i, j, k) dans ce dernier. Dans le cas où plusieurs valeurs ont la même occurrence, le mode retenu correspond à la valeur qui a la plus forte occurrence dans un voisinage autour du groupement courant ;

- Puis pour chaque groupe de mailles :

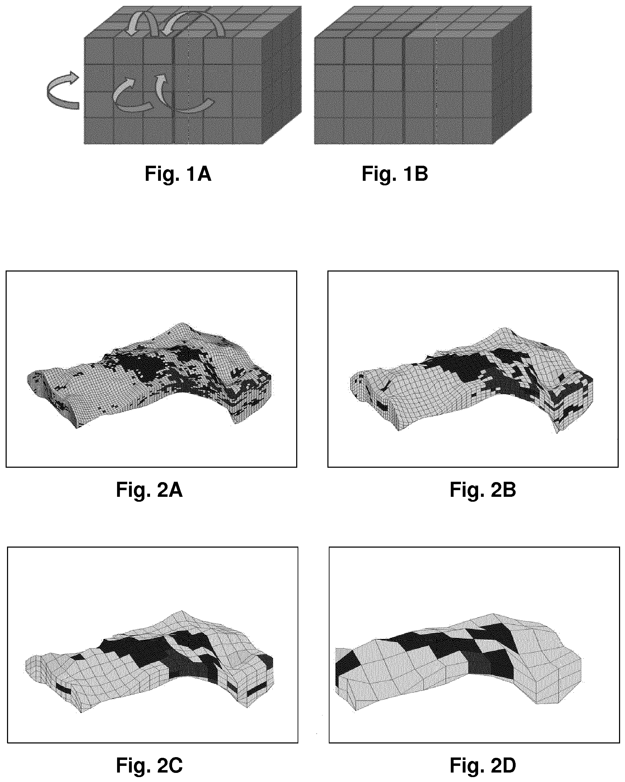

  ○ la valeur trouvée en la maille (i, j, k) est placée dans la position (1, 1, 1) de chaque groupe, comme l'illustre la Figure 1A dans laquelle les modes de chaque groupe de mailles de dimension 3x2x2 sont identifiés par les cubes en gris foncé ;

  ○ les valeurs aux positions (i', j', k') ≠ (1, 1, 1) dans un groupe sont mises à jour en soustrayant le mode, de la façon suivante :

$$V ((i', j', k') \neq (1, 1, 1)) = V ((i', j', k') \neq (1, 1, 1)) - V (1, 1, 1) \ ;$$

  ◦ La position (i, j, k) du mode dans le groupe est stockée de façon indépendante en coordonnée linéaire dans un tableau T1 ;

- Une fois l'ensemble des groupes traité, les modes V (1, 1, 1) sont regroupés comme l'illustre les flèches en Figure 1A, le résultat de ce regroupement étant présenté en Figure 1B. Cette étape, nommée décomposition par la suite, peut être mise en œuvre selon un algorithme du type :

*Pour x' allant de 1 à DFi par pas de 2*

*Pour y' allant de 1 à DFj par pas de 2*

*Pour z' allant de 1 à DFk par pas de 2*

$$T2(x', y', z') \leftrightarrow T2(\frac{1+x'}{2}, \frac{1+y'}{2}, \frac{1+z'}{2})$$

*Fin Pour*

*Fin Pour*

*Fin Pour*

Comme montré en Figure 1B, on obtient dans la partie supérieure gauche du tableau tridimensionnel T2 l'ensemble des modes ainsi déterminés (groupe de mailles en gris foncé en Figure 1B), cette partie du tableau correspondant à la représentation maillée de résolution inférieure déterminée par le procédé selon l'invention. Le restant de ce tableau (mailles en gris clair en Figure 1B) contient les paramètres de passage du procédé selon l'invention, permettant de reconstituer la représentation maillée initiale à partir de la représentation de plus basse résolution.

## Exemple 2

Un deuxième exemple d'application concerne la mise en œuvre du procédé selon l'invention sur un modèle géologique à mailles fines d'une formation souterraine comprenant environ un million de mailles. La représentation maillée de ce modèle géologique, notée R1 par la suite, est présentée en Figure 2A. Les Figures 2B, 2C et 2D correspondent à des représentations maillées, notées respectivement R2, R3, et R4, de plus en plus basse résolution de la représentation maillée initiale R1, la dimension des mailles des représentations maillées étant multipliées par deux dans chaque direction de l'espace entre la représentation R1 et la représentation R2, entre la représentation R2 et la représentation R3, et entre la représentation R3 et la représentation R4. Ainsi la représentation maillée R4 ne contient plus qu'environ 2000 mailles. Par ailleurs, chacune des mailles des représentations maillées présentées en Figures 2A, 2B, 2C, et 2D comporte une valeur de propriété catégorielle, valeur représentée par une nuance de gris (les échelles de couleur sont identiques d'une figure à une autre).

Le critère pour déterminer la valeur représentative (ou mode) de la propriété catégorielle considérée pour chaque groupe de mailles de dimension 2x2x2 d'une représentation maillée donnée est celui de l'occurrence maximale combinée avec la longueur de corrélation maximale (cf sous-étape 1.1) dans le groupe considéré. Ce critère apparait particulièrement adapté puisqu'on peut constater une cohérence de localisation des valeurs de la propriété catégorielle d'une résolution à une autre (Figures 2A, 2B, 2C, et 2D).

## Exemple 3

Un troisième exemple d'application concerne la mise en œuvre du procédé selon l'invention sur un modèle géologique d'une formation souterraine, représenté par une représentation maillée initiale R1 de dimension 1000x1000x1000 (soit 1 milliard de mailles). A partir de cette représentation maillée, on a déterminé selon le procédé selon l'invention trois autres représentations, notées respectivement R2, R3, et R4, de plus en plus basse résolution, la dimension des mailles des représentations maillées étant multipliées par deux dans chaque direction de l'espace entre la représentation R1 et la représentation R2, entre la représentation R2 et la représentation R3, et entre la représentation R3 et la représentation R4. La taille mémoire des représentations multi-résolutions en partant de l'original R1 est donc de fait divisée par 8 à chaque passage vers une résolution plus grossière Rn+1, avec n compris entre 1 et 3, comme montré dans la première ligne du Tableau 1.

Les paramètres de passage du procédé selon l'invention ont par ailleurs été déterminés par une soustraction appliquée entre mode et valeurs de propriété catégorielle dans chacune des mailles d'un groupe (cf sous-étape 1.2), et ce, pour chaque groupe de mailles. La deuxième ligne du Tableau 1 précise la taille mémoire requise pour stocker les paramètres de passage permettant de passer d'une représentation maillée donnée à une représentation de résolution directement supérieure (soit de R4 à R3, de R3 à R2 et de R2 à R1). Cet exemple montre bien le gain en taille mémoire procuré par le procédé selon l'invention puisque la taille mémoire globale à stocker pour une résolution donnée (somme de la taille mémoire des représentations maillées et de la taille mémoire des paramètres de passage d'une résolution donnée) est égale à la taille mémoire de la seule représentation maillée (c'est-à-dire sans paramètres de passage) de la résolution supérieure.

Tableau 1

| | R1 | R2 | R3 | R4 |
|---|---|---|---|---|
| Taille mémoire des représentations maillées (Mo) | 4000 | 500 | 70 | 8 |
| Taille mémoire des paramètres de passage (Mo) | 0 | 3500 | 430 | 62 |

Ainsi le procédé selon l'invention permet, à partir d'une première représentation maillée dont chaque maille comporte au moins une valeur de propriété catégorielle, de déterminer au moins une seconde représentation maillée de résolution inférieure, dont les valeurs de propriétés catégorielles sont cohérentes avec celles de la représentation de résolution directement supérieure. De plus, le procédé selon l'invention déterminant des paramètres de passage pour reconstituer la représentation maillée de résolution supérieure au moyen de la représentation maillée de résolution inférieure et d'une combinaison linéaire, il n'est plus nécessaire de conserver la représentation maillée de résolution supérieure. Lorsque la combinaison linéaire en question est une soustraction, ces paramètres de passage, lorsqu'ils sont conservés dans un tableau informatique, ont une taille mémoire plus faible que la taille mémoire de la représentation maillée de résolution supérieure, ce qui est particulièrement avantageux en termes de stockage d'information, mais aussi en termes de vitesse de transfert d'information.

## Revendications

1. Procédé d'exploitation d'une formation souterraine comportant des hydrocarbures, à partir de mesures d'au moins une propriété catégorielle relative à ladite formation, dans lequel, au moyen d'un ordinateur, on construit une première représentation maillée représentative de ladite formation, chaque maille de ladite première représentation comportant une valeur de ladite propriété catégorielle, et dans lequel, à partir de ladite première représentation maillée, on construit au moins une seconde représentation maillée de la dite formation, la résolution de ladite seconde représentation étant inférieure à la résolution de ladite première représentation, de sorte qu'une maille de ladite seconde représentation corresponde à un groupe de mailles de ladite première représentation, et, pour chacune desdites mailles de ladite seconde représentation et pour ladite propriété, on réalise au moins l'étape suivante :

   A. on détermine une valeur représentative des valeurs de ladite propriété dans lesdites mailles dudit groupe de mailles de ladite première représentation correspondant à ladite maille de ladite seconde représentation, et on assigne ladite valeur représentative à ladite maille de ladite seconde représentation,

   le procédé étant **caractérisé en ce qu'**on réalise au moins l'étape suivante :
   B. on détermine des paramètres de passage de ladite seconde représentation à ladite première représentation au moyen d'une combinaison linéaire appliquée entre la valeur assignée à ladite maille de ladite seconde représentation et les valeurs de ladite propriété dans les mailles du groupe de mailles de ladite première représentation correspondant à ladite maille de ladite seconde représentation, lesdits paramètres de passage permettant de reconstruire ladite première représentation à partir de ladite seconde représentation, ladite combinaison linéaire consistant en une soustraction ;
   et **en ce que**, au moyen d'au moins ladite seconde représentation, desdits paramètres de passage et de ladite combinaison linéaire, on détermine au moins ledit schéma d'exploitation optimal des hydrocarbures de ladite formation, et on exploite ladite formation en fonction dudit schéma d'exploitation.

**2.** Procédé selon la revendication 1, dans lequel ladite détermination dudit schéma d'exploitation comprend la détermination itérative d'une série de N représentations maillées $R_n$ de résolutions inférieures à la résolution de ladite première représentation $R_1$, avec n variant entre 3 et N, **caractérisé en ce que**, la détermination de la $n^{ième}$ représentation $R_n$ est réalisée selon au moins les étapes suivantes :

  i. on reconstitue ladite première représentation $R_1$ au moyen de la représentation $R_{n-1}$ déterminée à l'itération n-1, ainsi que les paramètres de passage et la combinaison linéaire déterminés à l'itération n-1 ;
  ii. on applique lesdites étapes A et B à partir de ladite première représentation reconstituée $R_1$ et pour ladite $n^{ième}$ représentation $R_n$.

**3.** Procédé selon l'une des revendications précédentes, dans lequel au moins une desdites représentations maillées de résolution inférieure à la résolution de ladite première représentation est déterminée dans au moins une zone d'intérêt de ladite formation, telle qu'une zone le long d'un puits, une zone le long d'un horizon, une zone le long d'une faille.

**4.** Procédé selon l'une des revendications précédentes, dans lequel ladite valeur représentative correspond à la valeur de ladite propriété ayant la plus forte occurrence et/ou la plus grande longueur de corrélation dans ledit groupe de mailles de ladite première représentation.

**5.** Procédé selon l'une des revendications précédentes, dans lequel lesdites étapes A et B sont réitérées pour chacune des propriétés catégorielles relatives à ladite formation.

**6.** Procédé selon l'une des revendications précédentes, dans lequel on détermine un schéma d'exploitation optimal au moyen d'au moins une visualisation desdites représentations maillées de résolutions différentes et/ou au moyen de simulations d'écoulement réalisées sur des représentations maillées de résolutions différentes.

**7.** Procédé selon l'une des revendications précédentes, dans lequel ladite propriété catégorielle correspond à une lithologie, une perméabilité relative après classification, une pression fluide après classification, ou une saturation en huile après classification.

**8.** Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une des revendications précédentes, lorsque ledit programme est exécuté sur un ordinateur.

**Patentansprüche**

**1.** Verfahren zur Ausbeutung einer Kohlenwasserstoffe aufweisenden unterirdischen Formation ausgehend von Messungen mindestens einer kategorialen Eigenschaft bezüglich der Formation, wobei eine erste für die Formation repräsentative vermaschte Darstellung mittels eines Computers konstruiert wird, wobei jede Masche der ersten Darstellung einen Wert der kategorialen Eigenschaft aufweist, und wobei ausgehend von der ersten vermaschten Darstellung mindestens eine zweite vermaschte Darstellung der Formation konstruiert wird, wobei die Auflösung der zweiten Darstellung niedriger ist als die Auflösung der ersten Darstellung, so dass eine Masche der zweiten Darstellung einer Gruppe von Maschen der ersten Darstellung entspricht, und für jede der Maschen der zweiten Darstellung und für die Eigenschaft mindestens der folgende Schritt durchgeführt wird:

  A. es wird ein für die Werte der Eigenschaft in den Maschen der Gruppe von Maschen der ersten Darstellung entsprechend der Masche der zweiten Darstellung repräsentativer Wert bestimmt, und der repräsentative Wert wird der Masche der zweiten Darstellung zugewiesen,

  wobei das Verfahren **dadurch gekennzeichnet ist, dass** mindestens der folgende Schritt durchgeführt wird:
  B. es werden Übergangsparameter von der zweiten Darstellung zur ersten Darstellung mittels einer linearen Kombination bestimmt, die zwischen dem der Masche der zweiten Darstellung zugewiesenen Wert und den Werten der Eigenschaft in den Maschen der Gruppe von Maschen der ersten Darstellung entsprechend der Masche der zweiten Darstellung angewendet wird, wobei die Übergangsparameter es ermöglichen, die erste Darstellung ausgehend von der zweiten Darstellung zu rekonstruieren, wobei die lineare Kombination aus einer Subtraktion besteht;
  und dass mittels mindestens der zweiten Darstellung, der Übergangsparameter und der linearen Kombination mindestens der optimale Ausbeutungsplan der Kohlenwasserstoffe der Formation bestimmt wird, und die Formation abhängig vom Ausbeutungsplan ausgebeutet wird.

2. Verfahren nach Anspruch 1, wobei die Bestimmung des Ausbeutungsplans die iterative Bestimmung einer Reihe von N vermaschten Darstellungen $R_n$ mit niedrigeren Auflösungen als die Auflösung der ersten Darstellung $R_1$ enthält, mit n zwischen 3 und N variierend, **dadurch gekennzeichnet, dass** die Bestimmung der n-ten Darstellung $R_n$ gemäß mindestens den folgenden Schritten durchgeführt wird:

> i. es werden die erste Darstellung $R_1$ mittels der in der Iteration n-1 bestimmten Darstellung $R_{n-1}$ sowie die in der Iteration n-1 bestimmten Übergangsparameter und lineare Kombination wiederhergestellt;
> ii. die Schritte A und B werden ausgehend von der ersten wiederhergestellten Darstellung $R_1$ und für die n-te Darstellung $R_n$ angewendet.

3. Verfahren nach einem der vorhergehenden Ansprüche, wobei mindestens eine der vermaschten Darstellungen mit niedrigerer Auflösung als die Auflösung der ersten Darstellung in mindestens einem Bereich von Interesse der Formation bestimmt wird, wie ein Bereich entlang eines Bohrlochs, ein Bereich entlang eines Horizonts, ein Bereich entlang einer Verwerfung.

4. Verfahren nach einem der vorhergehenden Ansprüche, wobei der repräsentative Wert dem Wert der Eigenschaft entspricht, der die größte Häufigkeit und/oder die größte Korrelationslänge in der Gruppe von Maschen der ersten Darstellung hat.

5. Verfahren nach einem der vorhergehenden Ansprüche, wobei die Schritte A und B für jede der kategorialen Eigenschaften bezüglich der Formation wiederholt werden.

6. Verfahren nach einem der vorhergehenden Ansprüche, wobei ein optimaler Ausbeutungsplan mittels mindestens einer Visualisierung der vermaschten Darstellungen unterschiedlicher Auflösungen und/oder mittels Strömungssimulationen bestimmt wird, die auf vermaschten Darstellungen unterschiedlicher Auflösungen hergestellt werden.

7. Verfahren nach einem der vorhergehenden Ansprüche, wobei die kategoriale Eigenschaft einer Lithologie, einer relativen Permeabilität nach Klassifizierung, einem Fluiddruck nach Klassifizierung, oder einer Ölsättigung nach Klassifizierung entspricht.

8. Computerprogrammprodukt, das von einem Kommunikationsnetz herunterladbar und/oder auf einem computerlesbaren Träger gespeichert und/oder von einem Prozessor ausführbar ist, das Programmcodeanweisungen zur Durchführung des Verfahrens nach einem der vorhergehenden Ansprüche enthält, wenn das Programm auf einem Computer ausgeführt wird.

**Claims**

1. Method of exploiting an underground formation containing hydrocarbons on the basis of measurements of at least one categorical property relating to said formation, in which, by means of a computer, a first meshed representation of said formation is constructed, each mesh of said first representation including a value of said categorical property, and in which, on the basis of said first meshed representation, at least one second meshed representation of said formation is constructed, the resolution of said second representation being lower than the resolution of said first representation, with the result that a mesh of said second representation corresponds to a group of meshes of said first representation, and, for each of said meshes of said second representation and for said property, at least the following step is executed:

> A. a value representing values of said property in said meshes of said group of meshes of said first representation corresponding to said mesh of said second representation is determined, and said representative value is assigned to said mesh of said second representation,

the method being **characterized in that** at least the following step is executed:
B. change parameters for going from said second representation to said first representation are determined by means of a linear combination applied between the value assigned to said mesh of said second representation and the values of said property in the meshes of the group of meshes of said first representation corresponding to said mesh of said second representation, said change parameters allowing said first representation to be reconstructed on the basis of said second representation, said linear combination consisting of a subtraction;

and **in that**, by means of at least said second representation, said change parameters and said linear combination, there is determined at least said optimum exploitation scheme of the hydrocarbons of said formation and said formation is exploited as a function of said exploitation scheme.

2. Method according to Claim 1, in which said determination of said exploitation scheme includes the iterative determination of a series of N meshed representations Rn with resolutions lower than the resolution of said first representation R1, with n varying between 3 and N, **characterized in that** the determination of the nth representation Rn is produced by means of at least the following steps:

   i. said first representation R1 is reconstituted by means of the representation $R_{n-1}$ determined in the iteration n-1 and the change parameters and the linear combination determined in the iteration n-1;
   ii. said steps A and B are applied on the basis of said reconstituted first representation R1 and for said nth representation Rn.

3. Method according to either one of the preceding claims, in which at least one of said meshed representations having a resolution lower than the resolution of said first representation is determined in at least one zone of interest of said formation such as a zone along a well, a zone along a horizon, a zone along a fault.

4. Method according to any one of the preceding claims, in which said representative value corresponds to the value of said property having the highest occurrence and/or the greatest correlation length in said group of meshes of said first representation.

5. Method according to any one of the preceding claims, in which said steps A and B are repeated for each of the categorical properties relating to said formation.

6. Method according to any one of the preceding claims, in which an optimum exploitation scheme is determined by means of at least one visualization of said meshed representations having different resolutions and/or by means of flow simulations executed on meshed representations having different resolutions.

7. Method according to any one of the preceding claims, in which said categorical property corresponds to a lithology, a relative permeability after classification, a fluid pressure after classification or an oil saturation after classification.

8. Computer program product downloadable from a communication network and/or stored on a computer-readable medium and/or adapted to be executed by a processor, including program code instructions for executing the method according to any one of the preceding claims when said program is executed on a computer.

Fig. 1A          Fig. 1B

Fig. 2A                    Fig. 2B

Fig. 2C                    Fig. 2D

**EP 3 252 508 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015157186 A1

**Littérature non-brevet citée dans la description**

- **CHRISTIE, M.A. ; BLUNT, M.J.** Tenth SPE Comparative Solution Project: A Comparison of Upscaling Techniques. *SPE Reservoir Engineering and Evaluation,* 2001, vol. 4, 308-317
- **P. CIGNONI ; C. MONTANI ; R. SCOPIGNO.** A comparison of mesh simplification algorithms. *Computers & Graphics,* 1997, vol. 22, 37-54
- **CALLAHAN STEVEN P. ; COMBA JOAO L.D. ; SHIRLEY PETER ; SILVA CLAUDIO T.** Interactive rendering of large unstructured grids using dynamic level-of-detail. *Visualization, 2005. VIS 05. IEEE,* 199-206